# EUROPÄISCHE PATENTSCHRIFT

(11) **EP 0 942 073 B1**
(45) Veröffentlichungstag und Bekanntmachung des Hinweises auf die Patenterteilung: **25.08.2004**
(21) Anmeldenummer: 99101158.6
(22) Anmeldetag: 22.01.1999
(51) Int. Cl.: C23C 14/34

(54) **Verfahren zur Herstellung eines Sputtertargets zum Abscheiden nitridischer oder oxidischer Siliziumschichten**
Process for the production of a sputter target for deposition of oxidised or nitrided silicon layers
Procédé de fabrication d'une cible de pulvérisation pour la déposition des couches en oxyde ou nitrure de silicium

(30) Priorität: 10.03.1998 DE 19810246
(43) Veröffentlichungstag der Anmeldung: 15.09.1999
(73) Patentinhaber: W.C. Heraeus GmbH & Co. KG, 63450 Hanau (DE)
(72) Erfinder: Weigert, Martin Dr., 63457 Hanau (DE); Konietzka, Uwe, 63826 Geiselbach (DE)
(74) Vertreter: Kühn, Hans-Christian

(56) Entgegenhaltungen:
- EP-A- 0 165 413
- EP-A- 0 536 607
- DE-A- 19 527 476
- US-A- 5 094 288

## Beschreibung

Die Erfindung betrifft ein Verfahren zur Herstellung eines Sputtertargets zum Abscheiden nitridischer oder oxidischer Siliziumschichten durch reaktive Kathodenzerstäubung, wie beispielsweise Si₃N₄ oder SiO₂ als optische Funktionsschichten auf Glassubstraten, wobei das Targetmaterial ein gegossener und aus dem Schmelzzustand erstarrter Siliziumkörper mit einem der Schmelze zugemischten Dotierungsstoff ist.

Nitridische und oxidische Silizium-Dünnschichten erlangen steigende Bedeutung in der modernen Glasbeschichtung. Üblicherweise werden diese Schichten durch Sputtertechnik aufgebracht. Von einem leicht dotierten Siliziumtarget wird unter O₂ oder NO₂ Reaktivgasbeigabe eine Si₃N₄- oder SiO₂-artige Schicht abgeschieden. Als Targetmaterial wird für flache Sputterkathoden üblicherweise polykristallines hochreines bor- oder phosphordotiertes Silizium benutzt.

Bekannt ist ein Verfahren zum Aufbringen von optisch transparenten Schichten aus Verbindungen des Siliziums auf Substraten durch reaktive Kathodenzerstäubung von siliziumhaltigen Targetmaterialien (EP 0 165 413), wobei als Targetmaterial ein gegossener und aus dem Schmelzzustand erstarrter polykristalliner Siliziumformkörper aus mindestens 99 % Silizium mit der Schmelze zugemischten Dotierungsstoffen aus der Gruppe Bor, Antimon, Phosphor und Arsen in einer ein Reaktionsgas aus der Gruppe Sauerstoff und Stickstoff enthaltenden Atmosphäre mittels Gleichspannung zerstäubt wird.

Es ist weiterhin bekannt, für Rotationskathoden auf rohrförmigen Stahlträgern plasmagespritzte Silizium-Targets einzusetzen.

Das für Flachkathoden eingesetzte hochreine dotierte Siliziumtargetmaterial wird in der Regel als Nebenprodukt aus der Herstellung von Siliziumscheiben für die Photovoltaik gewonnen. Dazu werden langsam kristallisierte Kacheln für die Kathodenbestückung umgearbeitet. Diese Kacheln werden dann durch Löt- oder Klebetechniken zu einer Großkathode zusammengefügt.

Bekannt ist auch ein Sputtertarget, insbesondere mit großen Abmessungen und aus brüchigen Werkstoffen, wie z. B. Si, Ge, In₂O₃, SnO₂ (DE-OS 195 27 476), bestehend aus einer Targetgrundplatte und aus einer zwischen dem Sputterwerkstoff und der Grundplatte angeordneten Schicht aus einem Kleber, vorzugsweise aus einem mit einem Metallpulver vermischten Epoxidharz-Kleber, wobei der Targetwerkstoff unter Zwischenschaltung der Kleberschicht unmittelbar auf die Grundplatte aufgebracht ist und das Metallpulver aus Kupfer, Nickel, Gold oder Eisen gebildet ist.

Schließlich ist ein Target für die in einer evakuierbaren, mit einem Prozeßgas füllbaren Prozeßkammer angeordneten Kathode einer Vorrichtung zum Beschichten von Werkstücken bekannt (DE-OS 42 42 079) mit einem Kathodenkörper und mit einer Vielzahl auf dem Kathodenkörper und einer Reihe nebeneinander liegend angeordneten, zusammen das Target bildenden Targetkacheln und mit mindestens einer zwischen den Targetkacheln und dem Kathodenkörper angeordneten Targetgrundplatte, wobei die aus dem abzusputternden Werkstoff gebildeten Targetkacheln jeweils eine parallelepipede Konfiguration aufweisen und jeweils fest mit einer ähnlich dimensionierten Targetgrundplatte verlötet, verschweißt oder verklebt sind, wobei die Grundflächen der Targetgrundplatten in ihrer Länge geringfügig größer bemessen sind als die Grundfläche der jeweils zugehörigen Targetkachel, wobei die in der Breite jeweils über den Rand der Targetkachel hervorstehenden beiden Randpartien der Targetgrundplatte mit Hilfe von Pratzleisten fest am Kathodenkörper gehalten sind.

Der vorliegenden Erfindung liegt nun die Aufgabe zugrunde, ein Verfahren zur Herstellung eines Targets, wobei das Target für die Herstellung oxidischer oder nitridischer Siliziumschichten geeignet und insbesondere besonders preiswert in Gestalt von Kacheln ausformbar ist.

Diese Aufgabe wird gemäß dem Patentanspruch dadurch gelöst, daß als Targetmaterial Silizium mit einer Dotierung von 1 Gew.% bis 15 Gew.% Aluminium in eine Form eingegossen wird die der erstarrten Schmelze die Form einer Kachel, vorzugsweise in Gestalt eines flachen parallelepipeden Formkörpers verleiht.

Das Basistargetmaterial, dem eine Dotierung von Silizium beigemischt ist, wird in eine endmaßnahe Gußform eingegossen. Mit vergleichsweise geringem Schleif- und Schneideaufwand können die erstarrte endmaßnahen gegossenen Rohlinge in einzelne Targetkacheln umgearbeitet werden, die dann durch Löt-, Klebe- oder Pratzverfahren zu einer Kathode zusammengesetzt werden.

Überraschenderweise zeigt sich, daß mit Sputtertargets aus diesen endmaßnah gegossenen Silizium(Al)-Kacheln trotz vorhandener Gußfehler wie Mikroporen und -risse und trotz der hohen Aluminiumdotierung Siliziumoxid oder -nitrid-Schichten mit vergleichbaren optischen Kenngrößen gesputtert werden können.

### Beispiel:

Aus technisch reinem Silizium und Aluminium, d. h. jeweils 99,5 % metallischer Reinheit, wurden in einen Vakuum-Induktionsofen verschiedene Legierungen eingeschmolzen. Als Tiegelmaterial wurde Graphit eingesetzt. Als Gußform wurde eine Kokille mit den Maßen 110 mm Breite, 16 mm Dicke und 330 mm Höhe verwendet. Die Gußforn aus Graphit wurde auf ca. 200°C vorgewärmt und unmittelbar vor dem Abguß in den Vakuumofen eingeschleust.

Folgende Legierungen wurden erschmolzen:
a) Si 99,5% Reinheit ohne Al-Dotierung
b) Si 99,5% Reinheit + 1 Gew.% Al
c) Si 99,5% Reinheit + 5 Gew.% Al
d) Si 99,5% Reinheit + 15 Gew.% Al

Während mit reinem Silizium (Beispiel a) auch nach Variation der Abgußbedingungen nur völlig zerbrochene Gußteile hergestellt werden konnten, war es bereits ab 1 Gew.% Al Beilegierung möglich, intakte Platten zu erzeugen. Die Gußplatten mit 1 Gew.% Al erweisen sich allerdings als äußerst rißempfindlich während der Schleif- und Sägebearbeitung.

Aus den Kacheln mit 1 Gew.%, 5 Gew.% und 15 Gew.% Aluminiumgehalt wurden durch Schleifen der Oberfläche und Trennen mit einer Diamant-Trennscheibe jeweils Targetkacheln der Größe 100 x 100 x 14 mm hergestellt. Zur Charakterisierung der Gußfehler wurde jeweils die Dichte bestimmt.

Sputterversuche mit 5 Gew.% Al und 15 Gew.% Al ergaben durchaus vergleichbare optische Kenndaten verglichen mit dünnen nitridischen oder oxidischen Siliziumschichten, hergestellt aus hochreinem Silizium. Die wesentlichen Ergebnisse sind in der nachstehenden Tabelle Zusammengefaßt:

| | theoretische Dichte des Targets | gemessene Dichte des Targets | Brechungsindex (550 nm) Si₃(Al)N₄ | Brechungsindex (550 nm) Si(Al)O₂ |
|---|---|---|---|---|
| Si + 1 Gew.% Al | 2,33 | 2,18 | - | - |
| Si + 5 Gew.% Al | 2,33 | 2,26 | 2,05 ± 0,02 | 1,46 ± 0,02 |
| Si + 15 Gew.% Al | 2,38 | 2,37 | 2,05 ± 0,02 | - |

## Patentansprüche

1. Verfahren zur Herstellung eines Sputtertargets zum Abscheiden nitridischer oder oxidischer Siliziumschichten durch reaktive Kathodenzerstäubung, wie beispielsweise Si₃N₄ oder SiO₂ als optische Funktionsschichten oder als Wärmeschutzschichten auf Glassubstraten, wobei das Targetmaterial in eine einen ein Parallelflach bildenden Hohlraum aufweisende Gussform eingegossen und aus dem Schmelzzustand zu einem Siliziumformkörper mit einem der Schmelze zugemischten Dotierungsstoff erstarrt, wobei als Dotierungsstoff Aluminium in einer Konzentration von 1 Gew.% bis 15 Gew.% verwendet wird.

## Claims

1. Process for the production of a sputter target for depositing nitrided or oxidic silicon layers by reactive cathode sputtering, such as, for example, Si₃N₄ or SiO₂, as optical functional layers or as heat insulation layers on glass substrates, the target material being poured into a mould which has a cavity which forms a parallel flat object and solidifying from the molten state to give a silicon moulding comprising a dopant admixed with the melt, aluminium in a concentration of 1% by weight to 15% by weight being used as the dopant.

## Revendications

1. Procédé de préparation d'une cible de pulvérisation pour le dépôt de couches de nitrure ou d'oxyde de silicium par pulvérisation cathodique réactive, comme par exemple Si₃N₄ ou SiO₂ en tant que couches optiques fonctionnelles ou en tant que couches de protection contre la chaleur sur des substrats en verre, dans lequel on verse la matériau de la cible dans un moule de coulée présentant un espace creux formant un parallélépipède, et on le solidifie à partir de l'état fondu pour former un corps moulé de silicium avec une substance dopante mélangée à la masse fondue, en utilisant comme substance dopante de l'aluminium à une concentration de 1 % en masse à 15 % en masse.
